Europäisches Patentamt

European Patent Office

Office européen des brevets

(11) Veröffentlichungsnummer: **0 503 377 A1**

# EUROPÄISCHE PATENTANMELDUNG

(21) Anmeldenummer: **92103314.8**

(22) Anmeldetag: **27.02.92**

(51) Int. Cl.5: **G03F 7/039**, G03F 7/20

(30) Priorität: **12.03.91 DE 4107851**

(43) Veröffentlichungstag der Anmeldung:
**16.09.92 Patentblatt 92/38**

(84) Benannte Vertragsstaaten:
**AT BE CH DE ES FR GB IT LI NL SE**

(71) Anmelder: **BASF Aktiengesellschaft**
**Carl-Bosch-Strasse 38**
**W-6700 Ludwigshafen(DE)**

(72) Erfinder: **Wuensch, Thomas, Dr.**
**Dr.-Dahlem-Strasse 8**
**W-6702 Bad Duerkheim(DE)**
Erfinder: **Hoessel, Peter, Dr.**
**Salierstrasse 71**
**W-6707 Schifferstadt(DE)**
Erfinder: **Hoffmann, Gerhard, Dr.**
**Pappelstrasse 22**
**W-6701 Otterstadt(DE)**
Erfinder: **Langen, Juergen, Dr.**
**Am Herrengarten 65**
**W-5300 Bonn 3(DE)**

(54) **Verfahren zur Herstellung von Mikroformkörpern mit hohem Aspektverhältnis.**

(57) Die Erfindung betrifft ein Verfahren zur Herstellung von Mikroformkörpern mit hohem Aspektverhältnis durch bildmäßiges Bestrahlen von Polymeren mit energiereicher paralleler Strahlung aus Röntgenstrahlquellen, wobei als Polymere Homo- oder Copolyoximethylene eingesetzt werden.

EP 0 503 377 A1

Die Erfindung betrifft ein Verfahren zur Herstellung von Mikroformkörpern mit hohem Aspektverhältnis, d.h., mit extrem großen Strukturhöhen bei Lateralabmessungen im Mikrometerbereich, durch Bestrahlen von Polymeren oder Polymermischungen und nachfolgender Entwicklung mit geeigneten Entwicklermedien.

Die Entwicklung der Mikroelektronik hat gezeigt, daß die konsequente Miniaturisierung und Integration zu einer unüberschaubaren Vielfalt neuer Produkte mit entsprechenden Technologien führt. Die Mikroelektronik hat in wenigen Jahren gegenüber anderen Industriezweigen einen gewaltigen Vorsprung in der Miniaturisierung gewonnen. Inzwischen zeichnet sich ab, daß in Zukunft auch andere Mikrotechniken eine große Bedeutung erlangen werden, wobei insbesondere die Mikromechanik und die integrierte Optik zu erwähnen sind. Solche Techniken eröffnen in der Kombination mit der Mikroelektronik eine unvorstellbare Zahl neuer elektronischer, optischer, biologischer und mechanischer Funktionselemente.

Bei einer Massenfertigung von nichtelektronischen Bauelementen, Systemkomponenten und Subsystemen der Mikrotechnik wird man naturgemäß die außerordentlich leistungsfähigen Fertigungsmethoden der Halbleitertechnik in möglichst großem Umfang nutzen. Gleichzeitig muß man versuchen, klassische Methoden der Feinwerktechnik für die Mikromechanik zu ertüchtigen und mit entsprechend modifizierten Halbleiterfertigungsmethoden zu verschmelzen, um so die engen Grenzen der Siliciumplanartechnik verlassen und neue Gesatltungsmöglichkeiten erschließen zu können, die auf einer Vielfalt von Formen und Materialien aufbauen. Diese Forderung wird z.B. in hohem Maße durch das LIGA-VErfahren erfüllt, das auf den Fertigungsschritten

- Lithographie,
- Galvanoformung und
- Abformung

aufgebaut und am Kernforschungszentrum Karlsruhe (KfK) entwickelt worden ist. Es ermöglicht die Herstellung von Mikrostrukturkörpern mit hohem Aspektverhältnis, d.h., mit Lateralabmessungen im Mikrometerbereich bei Strukturhöhen von mehreren hundert Mikrometern, aus Kunststoffen, Metallen und keramischen Massen.

Das LIGA-Verfahren basiert auf dem Konzept, durch einen Lithographieprozeß mit hoher Tiefenschärfe präzise Primärstrukturen mit großer Strukturhöhe herzustellen und diese Strukturen durch einen oder mehrere Abformungsprozesse vielfach zu replizieren. Dieses Fertigungskonzept kann flexibel an die durch das jeweilige Mikrostrukturprodukt vorgegebenen Randbedingungen angepaßt werden, die sich unter anderem auf die Geometrie, die verwendeten Werkstoffe oder auch auf die Stückzahl beziehen und die Art und Abfolge der einzelnen Fertigungsschritte festlegen.

Ein typischer Fertigungsablauf für die Massenfertigung von Mikrostrukturkörpern aus Metall nach dem LIGA-Verfahren enthält mehrere Prozeßschritte.

In einem ersten Prozeßschritt wird eine bis zu mehreren hundert Mikrometern dicke Polymerschicht auf einem elektrisch leitfähigen Substrat über eine Röntgenmaske mit hochintensiver, paralleler Röntgenstrahlung bestrahlt, die als sogenannte Synchrotronstrahlung in einem Elektronensynchrotron oder einem Elektronenspeicherring erzeugt wird.

Durch die Bestrahlung wird die Löslichkeit des Polymers oder der Polymermischung in ausgewählten Entwicklermedien so stark erhöht, daß die bestrahlten Materialbereiche entfernt werden können, wodurch eine reliefartige Polymerstruktur auf dem elektrisch leitenden Substrat entsteht.

Im nächsten Fertigungsschritt wird glavanisch Metall zwischen die Polymerstrukturen auf dem Substrat abgeschieden, so daß sich eine zum Polymerrelief komplementäre Metallstruktur ergibt. Setzt man die Metallabscheidung so lange fort, bis die Polymerstrukturen mit einer dicken Metallschicht überwachsen sind, so erhält man einen stabilen, zusammenhängenden Mikrostrukturkörper aus einheitlichem Material, der im nächsten Prozeßschritt als Formeinsatz für einen Abgießprozeß mit Kunststoff verwendet werden kann. Eine Massenfertigung von Mikrostrukturkörpern aus Kunststoff ist damit möglich.

Die dabei erzeugte Kunststoffstruktur kann entweder bereits das Endprodukt darstellen, oder man kann unter Verwendung einer metallischen Angießplatte wiederum eine Schablone für einen weiteren Galvanoformungsschritt erzeugen. Solche Schablonen sind wiederum in einer Vielzahl herstellbar.

Der beschriebene Fertigungsablauf kann an die Bedürfnisse spezieller Mikrostrukturen adaptiert werden, so daß mannigfach unterschiedliche Mikrostrukturen erzeugt werden können. Interessante Mikrostrukturprodukte sind Sensoren zur Messung von Beschleunigung, Durchfluß, Ultraschall, Feuchte u.ä., Mikromotoren, mikropneumatische Bauelemente, Mikrostecker für die Mikroelektronik, mikrooptische Bauelemente, Faseroptiken, Mikroelektroden, Spinndüsen, Mikrofilter, Gleitlager, Membrane und vieles andere mehr.

Der wesentliche Fertigungsschritt des LIGA-Verfahrens ist die strukturgenaue Bestrahlung des eingesetzten Polymeren. Die prinzipielle Durchführbarkeit des LIGA-Verfahrens konnte anhand einfacher Mikrostrukturen mit einem speziell hergestellten Polymethylmethacrylat (im folgenden PMMA genannt) nachgewiesen werden.

Bei der Umsetzung komplexer dreidimensionaler Strukturen hat sich gezeigt, daß PMMA einen hohen Bestrahlungsaufwand erfordert.

Weiter hat sich gezeigt, daß bei der Entwicklung der bestrahlten Polymeranteile mit einem geeigneten Entwicklermedium die unbestrahlten Polymeranteile quellen, wobei feine Mikrostrukturen zerstört werden können. Andererseits können gequollene Polymeranteile beim Austrocknen zu Spannungsrissen führen, die bei der Galvanik zu unbrauchbaren Mikrostrukturkörpern führen. Ursache für diese Probleme ist die hohe Lösungsmittelempfindlichkeit des PMMA.

Auch die mechanische Stabilität des Polymeren sollte für den LIGA-Prozeß verbessert werden. Bei der Galvanik des Mikrostrukturkörpers werden höhere Temperaturen erreicht, die teilweise zur Verbiegung von besonders kritischen Strukturen mit hohem Aspektverhältnis führen. Solche Strukturkörper können nicht mehr zur Abformung eingesetzt werden.

Aufgabe der Erfindung war es, ein geeignetes Polymer zu finden, welches die oben genannten Nachteile nicht aufweist. Ein für diese Aufgabe geeignetes Polymer sollte eine hohe Röntgenlichtempflichkeit aufweisen, unter dem Einfluß von Röntgenlicht depolymerisieren und mit speziellen Entwicklern selektiv entfernbar sein; das Polymere sollte ferner eine einfache Probekörperherstellung, beispielsweise durch Spritzguß, Pressen, Extrusion bzw. Gießen ermöglichen und keine Quellung, keine Spannungsrisse und keine Fehlstellen aufweisen.

Überraschenderweise wurde gefunden, daß Homo- und Copolyoximethylene diese Forderungen erfüllen.

Die Verwendbarkeit von Polyoximethylenen zur Herstellung von Mikroformkörpern, bei der es auf ein hohes Aspektverhältnis ankommt, wie dies für das LIGA-Verfahren erforderlich ist, und die sich dabei ergebenden Vorteile waren überraschend und konnten aus den bisher bekannten Druckschriften nicht hergeleitet werden.

Gegenstand der vorliegenden Erfindung ist ein Verfahren zur Herstellung von Mikroformkörpern mit hohem Aspektverhältnis durch bildmäßiges Bestrahlen von Polymeren mit energiereicher paralleler Strahlung aus Röntgenstrahlquellen, das dadurch gekennzeichnet ist, daß als Polymere Homo- oder Copolyoximethylene eingesetzt werden.

Unter Mikroformkörpern mit hohem Aspektverhältnis im Sinne der Erfindung werden Mikrostrukturkörper mit Strukturtiefen von mehreren $\mu$m bis in den mm-Bereich verstanden.

Als energiereiche parallele Strahlung wird dabei vorzugsweise Synchroton-Strahlung eingesetzt.

Das Homo- oder Copolyoximethylen kann dazu durch Spritzguß, Extrusion und/oder Pressen, vorzugsweise in Schichtdicken bis zu 2000 $\mu$m auf einen Träger aufgebracht werden.

Gegenstand der vorliegenden Erfindung ist auch ein Verfahren zur Herstellung von Mikrostrukturen, wobei das Homo- oder Copolyoximethylen nach bildmäßiger Betrahlung mit Synchrotronstrahlung und Behandlung mit selektiven Entwicklern, vorzugsweise z.B. mit Phenol oder wäßriger Mineralsäure, in einer Abtragstiefe von 50 bis 2000 $\mu$m bei lateralen Abmessungen von unter 10 $\mu$m strukturiert wird.

Als Aspektverhältnis im Sinne der Erfindung versteht man das Verhältnis von Höhe zu lateraler Dimension der Formkörperstrukturen bzw. der Reliefs oder das Verhältnis von maximaler Strukturhöhe zu minimaler lateraler Abmessung. Das Aspektverhältnis kann beim erfindungsgemäßen Verfahren in weiten Grenzen, beispielsweise zwischen 10:1 bis 1000:1, vorzugsweise zwischen 50:1 bis 100:1 variieren.

Die Bestrahlung erfolgt beim erfindungsgemäßen Verfahren mittels energiereicher paralleler Strahlung aus Röntgenstrahlquellen. Die Wellenlängen dieser Strahlen liegen in einem Bereich von 0,1 bis 10 nm, vorzugsweise 0,1 bis 1,0 nm.

Derartige Bestrahlungen können beispielsweise an einem Synchrotron mit speziellen Vorabsorbern, z.B. aus Beryllium oder Polyimidfolie (z.B. Kapton® der Fa. Du Pont de Nemours) mit einem Bestrahlungsaufwand von 200 bis 2000 mA•min. durchgeführt werden.

Der Bestrahlungsaufwand ist abhängig von der Elektronenenergie im Elektronenspeicherring, der vom Synchrotron abgezweigt ist. Im allgemeinen beträgt die Elektronenenergie 1,6 bis 2,3 Gev.

Zur bildmäßigen Bestrahlung werden üblicherweise spezielle Röntgenmasken, beispielsweise aus einer Titanträgerfolie mit Goldabsorberstrukturen verwendet.

Als Polymere werden erfindungsgemäß Homo- und Copolyoximethylene eingesetzt.

Polyoximethylene und deren Herstellung sind bekannt und bespielsweise in Methoden der organischen Chemie (Houben-Weyl), Georg Thieme Verlag Stuttgart (1963) Band XIV/2, Seiten 404 bis 410, bzw. Band E20 (1987) Seiten 1390 bis 1398) beschrieben. Auch ihre Lichtempfindlichkeit und die unter Einwirkung von $\gamma$-Strahlen durch photochemische Prozesse erhaltenen Reaktionsprodukte sind untersucht und in "The Radiation Chemistry of Macromolecules", edited by Malcolm Dole, Dept. of Chemistry, Baylor University, Waco, Texas, Vol. II, Academic Press New York, London 1973, Seiten 187 ff, beschrieben.

Für das erfindungsgemäße Verfahren geeignete Polyoximethylene sind Homopolymerisate des Formaldehyds oder Copolymerisate des Formaldehyds sowie des Trioxans mit cyclischen und/oder linearen Formalen, wie Butandiolformal oder Epoxiden, wie Ethylen- oder Propylenoxid. Die Homopolymerisate tragen in der Regel thermisch stabile Endgruppen, wie Ester- oder Ethergruppen. Die Copolymerisate des Formaldehyds oder des Trioxans weisen vorzugsweise mehr als 50 %, insbesondere mehr als 75 % Oximethylengruppen auf. Besonders bewährt haben sich Copolymerisate, in denen mindestens 0,1 % Gruppen eines Comonomeren wie z.B. Butandiolformal oder Ethylenoxid enthalten sind, das mindestens zwei benachbarte Kohlenstoffatome in der Kette hat. Besondere technische Bedeutung haben Polyoximethylene, die 1 bis 10 Gew.-% Comonomere enthalten. Solche Copolymerisate sind in an sich bekannter Weise durch kationische Copolymerisation von Trioxan mit geeigneten Comonomeren, wie cyclischen Ethern oder Acetalen, z.B. Ethylenoxid, 1,3-Dioxolan, 1,3-Dioxan, 1,3-Dioxacycloheptan oder mit linearen Oligo- oder Polyformalen, wie Polydioxolan oder Polybutandiolformal erhältlich. In der Regel haben die verwendeten Polyoximethylene ein Molekulargewicht (Zahlenmittel) $\overline{M}_n$ von 2000 bis 100000, vorzugsweise von 10000 bis 100000 und einem MFI bei 190°C, 21,17 N nach DIN 53 735 von 0,5 bis 200, vorzugsweise von 1 bis 100. Besondere Bedeutung haben Polymerisate, die aus Trioxan und 1 bis 10 Mol-% Ethylenoxid, 1,3-Dioxolan oder Butandiolformal aufgebaut sind.

Obwohl Polyoximethylene allgemein als säureempfindlich bekannt sind, konnten die bestrahlten Bereiche selektiv mit Säuren abgelöst werden, ohne daß ein Angriff auf unbestrahlte Bereiche stattfand. Die so erhaltenen Mikrostrukturen zeigten im Vergleich mit dem GG-Entwickler, wie in DE-C 30 39 110 für PMMA beschrieben, bei gleichen Bestrahlungsbedingungen erheblich größere Strukturtiefen. Auch die Entwicklung mit Basen führte zur selektiven Ablösung der bestrahlten Bereiche, die erzielten Strukturtiefen lagen aber unter denen, die bei Entwicklung mit Säuren erzielt werden konnten. Eine deutliche Verstärkung wurde durch den Einsatz der Entwickler in Kombination mit Ultraschall bzw. Megaschall erzielt. Unter diesen Bedingungen wurden in vielen Fällen erheblich größere Strukturtiefen erreicht als durch Entwicklung ohne Ultraschall bzw. Megaschall unter sonst identischen Bedingungen.

Ebenfalls als Entwickler geeignet ist Phenol, womit die bestrahlten Bereiche selektiv abgelöst werden können. Die Strukturtiefen sind auch hier deutlich größer als bei PMMA mit gleichem Bestrahlungsaufwand.

Die eingesetzten Polyoximethylene wurden sowohl vor der Bestrahlung als auch nach der Betrahlung/Entwicklung auf Stabilität gegenüber den im LIGA-Prozeß angewandten Galvanikbedingungen untersucht. Dabei zeigten sich keine negativen Veränderungen bei den eingesetzten Proben, was durch mechanische Tests im Vergleich mit unbestrahlten Proben nachgewiesen wurde. Es ließen sich so Strukturen mit lateralen Abmessungen unter 10 µm bei maximaler Strukturhöhe von mehreren hundert µm herstellen, die keine Defekte aufwiesen.

Den Polymeren können Stabilisatoren gegen thermooxidativen Abbau, Nukleierungsmittel sowie Costabilisatoren, jeweils in Mengen < 2 % zugesetzt sein.

Wie bereits oben erwähnt, können zur Herstellung von Formkörpern die Homo- und Copolyoximethylene als Granulat oder in Pulverform nach üblichen Verfahren, wie z.B. durch Pressen, Spritzguß und/oder Extrusion bei Temperaturen zwischen 20 und 240°C auf elektrisch leitende Metallträger, wie z.B. aus Nickel, Kupfer oder Stahl, auf die gegebenenfalls eine 0,1 bis 50 µm dicke Schicht aus einem weiteren Metall oder Metalloxid, z.B. Titan, aufgebracht wurde, gegebenenfalls unter Mitverwendung spezieller Haftlacke oder spezieller Haftvermittler aufgebracht und fixiert werden. Die Schichtdicke der Homo- und Copolymeren auf dem Metallträger liegt im allgemeinen zwischen 20 und 2000, vorzugsweise 50 bis 800, insbesondere zwischen 100 und 500 µm. Die Oberfläche der Homo- oder Copolymerschichten sollte zweckmäßigerweise möglichst glatt sein.

Nach dem bildmäßigen Bestrahlen wird mit geeigneten Entwicklermedien, d.h. geeigneten organischen Lösungsmitteln, wie Phenol oder wäßriger Mineralsäure wie z.B. verdünnter, ca. 10 %iger Salzsäure oder Salpetersäure bei 50 bis 150°C entwickelt.

Es lassen sich so Abträge bis 600 µm erzielen. Die so erhaltenen Mikrostrukturen zeigen scharfe, steile Kanten und glatte Wände und sind beständig gegenüber Galvanikbädern, d.h. z.B. sauren Kupfer- bzw. Nickelgalvanikbädern. Bei Temperaturen zwischen 20 und 60°C bleiben die Mikrostrukturen über 24 Stunden in den Galvanikbädern unverändert.

Die in den Beispielen genannten Teile und Prozente sind, soweit nicht anders angegeben, Gewichtsteile bzw. Gewichtsprozente.

Beispiel 1

Ein Copolymer aus Trioxan und Butandiolformal (z.B. Ultraform® N 2320 = Handelsprodukt der BASF Aktiengesellschaft) wurde als Probekörper (Abmessungen 30 x 10 x 2 mm) an einem Synchrotron mit einem Bestrahlungsaufwand von 1600 mA · min unter einer Kupferdrahtmaske bildmäßig bestrahlt. Der Abtrag fand bei der nachfolgenden Entwicklung mit Phenol bei 90°C/10 min statt. Die Abtragstiefe betrug 480 µm.

Vergleichsbeispiel 1

Ein Probekörper aus PMMA wurde entsprechend mit einem Bestrahlungsaufwand von 1600 mA $\cdot$ min behandelt. Der Abtrag betrug nur 50 $\mu$m. (Entwicklung mit GG-Entwickler).

Beispiel 2

Ein Homopolyoximethylen mit Acetylendgruppen (z.B. Delrin® 500 NC = Handelsprodukt der Fa. Du Pont de Nemours) wurde in Form eines Probekörpers (Abmessungen 30 x 10 x 2 mm) an einem Synchrotron mit einem Bestrahlungsaufwand von 1600 mA $\cdot$ min bestrahlt. Der Abtrag fand bei der nachfolgenden Entwicklung mit wäßriger HCl (10 %ig) bei 80°C/10 min statt. Die Abtragstiefe betrug 440 $\mu$m.

Vergleichsbeispiel 2

Ein Probekörper aus PMMA wurde entsprechend Beispiel 2 mit einem Bestrahlungsaufwand von 1600 mA $\cdot$ min behandelt. Der Abtrag betrug nur 50 $\mu$m.

Beispiel 3

Ein Copolymer aus Trioxan und Ethylenoxid (z.B. Hostaform® C 9021 = Handelsprodukt der Firma Hoechst AG) wurde als Probekörper (Abmessungen 30 x 10 x 2 mm) an einem Synchrotron mit einem Bestrahlungsaufwand von 1600 mA $\cdot$ min unter Verwendung einer Kupferdrahtmaske bildmäßig bestrahlt. Der Abtrag fand bei der nachfolgenden Entwicklung mit Phenol bei 90°C/10 min statt. Die Abtragstiefe betrug 660 $\mu$m.

Vergleichsbeispiel 3

Ein Probekörper aus PMMA wurde entsprechend Beispiel 3 mit einem Bestrahlungsaufwand von 1600 mA $\cdot$ min behandelt. Der Abtrag betrug nur 50 $\mu$m.

**Patentansprüche**

1. Verfahren zur Herstellung von Mikroformkörpern mit hohem Aspektverhältnis durch bildmäßiges Bestrahlen von Polymeren mit energiereicher paralleler Strahlung aus Röntgenstrahlquellen, dadurch gekennzeichnet, daß als Polymere Homo- oder Copolyoximethylene eingesetzt werden.

2. Verfahren nach Anspruch 1, dadurch gekennzeichnet, daß als energiereiche parallele Strahlung Synchrotronstrahlung eingesetzt wird.

3. Verfahren nach Anspruch 1 oder 2, dadurch gekennzeichnet, daß das Homo- oder Copolyoximethylen durch Spritzguß, Extrusion und/oder Pressen in Schichtdicken bis zu 2000 $\mu$m auf einen Träger aufgebracht wird.

4. Verfahren zur Herstellung von Mikrostrukturen, dadurch gekennzeichnet, daß das Homo- oder Copolyoximethylen nach bildmäßiger Betrahlung mit Synchrotronstrahlung und Behandlung mit selektiven Entwicklern in einer Abtragstiefe von 50 bis 2000 $\mu$m bei lateralen Abmessungen von unter 10 $\mu$m strukturiert wird.

5. Verfahren nach Anspruch 4, dadurch gekennzeichnet, daß als selektiver Entwickler Phenol oder wäßrige Mineralsäure eingesetzt wird.

Europäisches
Patentamt

**EUROPÄISCHER RECHERCHENBERICHT**

Nummer der Anmeldung

EP    92 10 3314

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | FR-A-2 027 575 (E.I DU PONT DE NEMOURS AND COMPANY) <br> * Seite 7, Zeile 10 - Zeile 32; Ansprüche 1,6; Tabellen * <br> --- | 1-4 | G03F7/039 <br> G03F7/20 |
| Y | POLYMER BULLETIN. <br> Bd. 8, Nr. 9/10, November 1982, HEIDELBERG DE <br> Seiten 469 - 472; <br> HATADA KOICHI ET AL: 'Highly sensitive self developing Electron-beam resist of aldehyde copolymer' <br> * das ganze Dokument * <br> --- | 1-4 | |
| A | MICROELECTRONIC ENGINEERING. <br> Bd. 4, Nr. 1, Mai 1986, AMSTERDAM NL <br> Seiten 35 - 56; <br> BECKER E.W. ET AL: 'Fabrication of microstructures with high aspect ratios and great structural heights by synchrotron radiation lithography, galvanoforming, and plastic moulding (LIGA process)' <br> * Seite 41, Absatz 3 - Seite 42, Absatz 2 * <br><br> ----- | 1-4 | **RECHERCHIERTE SACHGEBIETE (Int. Cl.5)** <br><br> G03F <br> G03C <br> B41C |

Der vorliegende Recherchenbericht wurde für alle Patentansprüche erstellt

| Recherchenort | Abschlußdatum der Recherche | Prüfer |
|---|---|---|
| DEN HAAG | 02 JULI 1992 | LUDI M.M.B. |